(19) Europäisches Patentamt
European Patent Office
Office européen des brevets

(11) **EP 3 334 075 A1**

(12) **EUROPEAN PATENT APPLICATION**

(43) Date of publication:
**13.06.2018 Bulletin 2018/24**

(51) Int Cl.:
*H04L 1/00* (2006.01)    *H04L 25/03* (2006.01)
*H03M 13/37* (2006.01)    *H03M 13/45* (2006.01)
*H04L 27/34* (2006.01)

(21) Application number: **16203534.9**

(22) Date of filing: **12.12.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Panasonic Intellectual Property
Corporation
of America
Torrance, CA 90503 (US)**

(72) Inventor: **KLENNER, Peter
63225 Langen (DE)**

(74) Representative: **Grünecker Patent- und
Rechtsanwälte
PartG mbB
Leopoldstraße 4
80802 München (DE)**

(54) **ITERATIVE DEMAPPING FOR SUPERPOSITION MODULATION**

(57)    The present invention provides a method and apparatus for demapping superposition modulated signals with improved efficiency. This is achieved by providing a separate iterative demapper for each layer of a superposition modulated signal, and to configure each demapper to exchange soft-information with the other demappers such that each layer is demapped on the basis of soft-information relating to all layers. In this manner, no hard decisions on the FEC decoder output have to be taken and no information is lost.

Fig. 9

**EP 3 334 075 A1**

**Description**

TECHNICAL FIELD

The present invention relates to the field of digital communications in the context of broadcasting digital data, and more specifically to a method and apparatus for demapping superposition modulated signals.

BACKGROUND OF THE INVENTION

Superposition modulation occurs as part of recent multiplexing methods for delivering different service types simultaneously to different types of users, e.g., stationary and mobile users. One example is called Layered-Division-Multiplexing (LDM) in ATSC 3.0 (cf. for instance the article "Low Complexity Layered Division for ATSC 3.0," by S. I. Park, et.al., IEEE Transactions on Broadcasting, vol. 62, no. 1, pp. 233-243, March 2016); another example is a novel DTT system called Wideband-Transmission Reuse-1 (WiB; cf. the article "WiB: a new system concept for digital terrestrial television (DTT)" by E. Stare, J. J. Giménez, and P. Klenner, IBC Conference 2016).

Multiplexing multiple signals into a compound signal is a common method in data communications to share a single medium. Traditionally, data carrying different services are multiplexed in time or frequency. These methods are called Time-Division-Multiplex (TDM) and Frequency-Division-Multiplex (FDM). Real-world applications for TDM and FDM can be found in DVB-T2, in which multiple so-called PLPs (Physical Layer Pipes), each characterized by their own modulation and time interleaver, are sharing a certain frequency band in dedicated time slots, and the Japanese ISDB-T standard with the prominent One-Seg system, in which data is carried in banded segments which are strictly separated in frequency domain thus allowing for power-saving partial reception of individual segments.

It has been long since known that FDM and TDM are not the most spectrally efficient methods to share a medium. Their benefit lays more with the ease of implementation. The article "Cooperative broadcasting" by P. P. Bergmans and T. M. Cover (IEEE Trans. Inf. Theory, vol. 20, no. 3, pp. 317-324, May 1974) shows that actually the superposition of different services increases the capacity over either TDM or FDM. Only recently, this form of multiplexing has found its way into a current standard, namely ATSC 3.0, where it is called Layered-Division-Multiplexing. The term "layer" refers to the individually signals before superposition.

Intuitively, the edge of superposition modulation over TDM/FDM in capacity is obtained due to the simultaneous transmission of more than one service without pausing to transmit data in either time domain or frequency domain.

Naturally, superposition modulation demands an iterative receiver, i.e., a first layer is detected while the remaining layers are, yet, unknown, but the knowledge about the first layer can then immediately be exploited to detect a second layer and so forth.

There are different variants as to which the knowledge of previously detected layers can be exploited for detecting the remaining layers. One particular variant is to check the first layer FEC decoder output by means of an outer BCH code or CRC code, if it was detected successfully. If success is reported, then the output of the FEC-decoder can be remapped to cells and these cells are then subtracted from the received cells. This process is called Successive Interference Cancellation (SIC). Provided that the upper layer was detected without errors, the received signal after SIC looks to the lower layer detector as if the upper layer never has been present.

In this form, the SIC represents the state-of-the-art detection approach for an LDM-signal. In actuality, it is more correctly described as a form of hard-decision SIC (hard-SIC, in the following), since the remapping of the upper layer FEC-decoder output to cells is equivalent to a hard-decision on the soft-information at the FEC-decoder output, and hard-decision always gives rise to information loss.

SUMMARY OF THE INVENTION

It is an object of the present invention to provide an improved method and apparatus for demapping a superposition of two or more modulated signals which can provide an SNR-gain compared to conventional hard-SIC.

This is achieved by the features as set forth in the independent claims. Preferred embodiments are the subject matter of dependent claims.

It is the particular approach of the present invention to provide a separate iterative demapper for each layer of a superposition modulated signal, and to configure each demapper to exchange soft-information with the other demappers such that each layer is demapped on the basis of soft-information relating to all layers. In this manner, no hard decisions on the FEC decoder output have to be taken and no information is lost.

According to a first aspect of the present invention, a method is provided for iteratively demapping a received signal which comprises a superposition of at least a first BICM-encoded signal and a second BICM-encoded signal. The method comprises the steps of initializing a priori L-values for the first signal and a priori L-values for the second signal; computing, from the received signal, a posteriori (channel) L-values for the first signal; updating a priori L-values for the first signal on the basis of the computed a posteriori L-values for the first signal; iterating, for the first signal, the steps of computing the a posteriori L-values and updating the a priori L-values. The method further comprises the steps of computing, from the received signal, a posteriori (channel) L-values for the second signal; updating a priori L-values for the second signal on the basis of the computed a posteriori L-values for the second signal; iterating, for the second signal, the steps of computing the a posteriori L-values and updating the a priori L-values. The method is characterized in that the a posteriori L-values for the first signal are computed on the basis of the a priori L-values for the first signal and the a priori L-values for the second signal, and in that the a posteriori L-values for the second signal are computed on the basis of the a priori L-values for the first signal and the a priori L-values for the second signal.

In a preferred embodiment, the a posteriori L-values ($L_{ch,0}$) for the first signal ($x_0$) and the a posteriori L-values ($L_{ch,1}$) for the second signal ($x_1$) are computed according to

$$L_{ch,0}(i) = \log \frac{\sum_{x_0 \in \mathcal{A}_0^0(i)} \sum_{x_1 \in \mathcal{A}_1} p(y|x_0, x_1) e^{-\sum_{m=0}^{\log_2(S_0)-1} c_0(m) L_{a,0}(m) - \sum_{n=0}^{\log_2(S_1)-1} c_1(n) L_{a,1}(n)}}{\sum_{x_0 \in \mathcal{A}_0^1(i)} \sum_{x_1 \in \mathcal{A}_1} p(y|x_0, x_1) e^{-\sum_{m=0}^{\log_2(S_0)-1} c_0(m) L_{a,1}(m) - \sum_{n=0}^{\log_2(S_1)-1} c_1(n) L_{a,1}(n)}}$$

and

$$L_{ch,1}(i) = \log \frac{\sum_{x_0 \in \mathcal{A}_0} \sum_{x_1 \in \mathcal{A}_1^0(i)} p(y|x_0, x_1) e^{-\sum_{m=0}^{\log_2(S_0)-1} c_0(m) L_{a,0}(m) - \sum_{n=0}^{\log_2(S_1)-1} c_1(n) L_{a,1}(n)}}{\sum_{x_0 \in \mathcal{A}_0} \sum_{x_1 \in \mathcal{A}_1^1(i)} p(y|x_0, x_1) e^{-\sum_{m=0}^{\log_2(S_0)-1} c_0(m) L_{a,0}(m) - \sum_{n=0}^{\log_2(S_1)-1} c_1(n) L_{a,1}(n)}},$$

wherein $y$ is the received signal, $\mathcal{A}_0$ and $\mathcal{A}_1$ denote the constellation alphabet for the first and the second signal, respectively, $S_0 = |\mathcal{A}_0|$ and $S_1 = |\mathcal{A}_1|$ denote the size of the respective constellation alphabet, $c_k(i) \in \{0,1\}$ is the value of the $i$-th bit mapped to cell $x_k \in \mathcal{A}_k$, and $\mathcal{A}_k^b(i)$ denotes the set of all cells from the alphabet $\mathcal{A}_k$ with bit $c_k(i) = b$, and $p(y|x_0,x_1)$ is the conditional probability of receiving $y$ given $x_0$ and $x_1$.

The method may further comprise the steps of computing extrinsic L-values for the first signal by subtracting the a priori L-values for the first signal from the a posteriori L-values for the first signal, wherein the a priori L-values for the first signal are updated on the basis of the extrinsic L-values for the first signal; and computing extrinsic L-values for the second signal by subtracting the a priori L-values for the second signal from the a posteriori L-values for the second signal, wherein the a priori L-values for the second signal are updated on the basis of the extrinsic L-values for the second signal.

In a preferred embodiment, the step of updating the a priori L-value for at least one of the first and the second signal comprises deinterleaving the extrinsic L-values for the at least one signal; performing FEC decoding on the deinterleaved extrinsic L-values for the at least one signal; subtracting the deinterleaved extrinsic L-values for the at least one signal from the result of the FEC decoding process; and interleaving a result of the subtraction.

In a preferred embodiment, the iterating steps are performed such that a first iteration for computing the a posteriori L-values for the first signal is based on the initialized a priori L-values for the first and the second signal and that a first iteration for computing the a posteriori L-values for the second signal is based on the updated a priori L-values for the first signal and on the initialized a priori L-values for the second signal. In this manner, iteration steps for the first and the second signal are be performed sequentially, while the demapping process for the second signal may rely on information provided by the demapping process for the first signal. This may be advantageous for a situation where the first signal dominates over the second signal.

In an alternative embodiment, the iterating steps are performed such that both a first iteration for computing the a posteriori L-values ($L_{ch,0}$) for the first signal ($x_0$) and a first iteration for computing the a posteriori L-values ($L_{ch,1}$) for the second signal ($x_1$) are based on the initialized a priori L-values ($L_{a,0}$, $L_{a,1}$) for the first and the second signal ($x_0$, $x_1$). In this manner, the method for iteratively demapping the received signal is strictly symmetric in the first and the second signal. Therefore, both signals are treated equal, which may be particularly useful in a situation where both signal strengths are on a par.

[0018]    A particularly important application of the method according to the present invention may be a situation, where the received signal is a layered-division multiplexing signal with the first signal representing a first layer and the second signal representing a second layer. Another important application may be a situation, where the first signal is a first wideband transmission signal transmitted by a first transmitter and the second signal is a second wideband transmission signal transmitted by a second transmitter in the same frequency band as the first wideband transmission signal.

According to a second aspect of the present invention, an apparatus is provided for iteratively demapping a received signal, which comprises a superposition of at least a first BICM-encoded signal and a second BICM-encoded signal. The apparatus comprises a first demapper for demapping the first signal from the received signal by iteratively computing a posteriori L-values of the first signal and updating a priori L-values of the first signal on the basis of the computed a posteriori L-values of the first signal, and a second demapper for demapping the second signal from the received signal by iteratively computing a posteriori L-values of the second signal and updating a priori L-values of the second signal on the basis of the computed a posteriori L-values of the second signal. The apparatus is characterized in that the first demapper is configured for computing the a posteriori L-values of the first signal on the basis of the a priori L-values of the first signal and the a priori L-values of the second signal; and the second demapper is configured for computing the a posteriori L-values of the second signal on the basis of the a priori L-values of the first signal and the a priori L-values of the second signal.

BRIEF DESCRIPTION OF THE DRAWINGS

The above and other objects and features of the present invention will become more apparent from the following description and preferred embodiments given in conjunction with the accompanying drawings, in which:

Fig. 1      is a block diagram illustrating the BICM-block of the i-th layer,

Fig. 2      is a block diagram illustrating Layered-Division-Multiplexing with two layers,

Fig. 3      is an illustration of a WiB transmission scenario,

Fig.4      is a block diagram illustrating a system model for superposition modulation applicable to LDM and WiB with two layers,

Fig. 5      is a block diagram of an upper layer demapper in accordance with an embodiment of the present invention,

Fig. 6      is a block diagram of a lower layer demapper in accordance with an embodiment of the present invention,

Fig.7      is a block diagram of a partial iterative demodulator of the first layer in accordance with an embodiment of the present invention,

Fig. 8      is a block diagram of a partial iterative demodulator of the second layer in accordance with an embodiment of the present invention,

Fig. 9      is a block diagram of an iterative demapper in accordance with an embodiment of the present invention,

Figs. 10A   is a schematic drawing illustrating the flow of information for iteratively demapping the first and the second layer in a sequential fashion, and

Figs. 10B   is a schematic drawing illustrating the flow of information for iteratively demapping the first and the second layer in a parallel fashion.

DETAILED DESCRIPTION

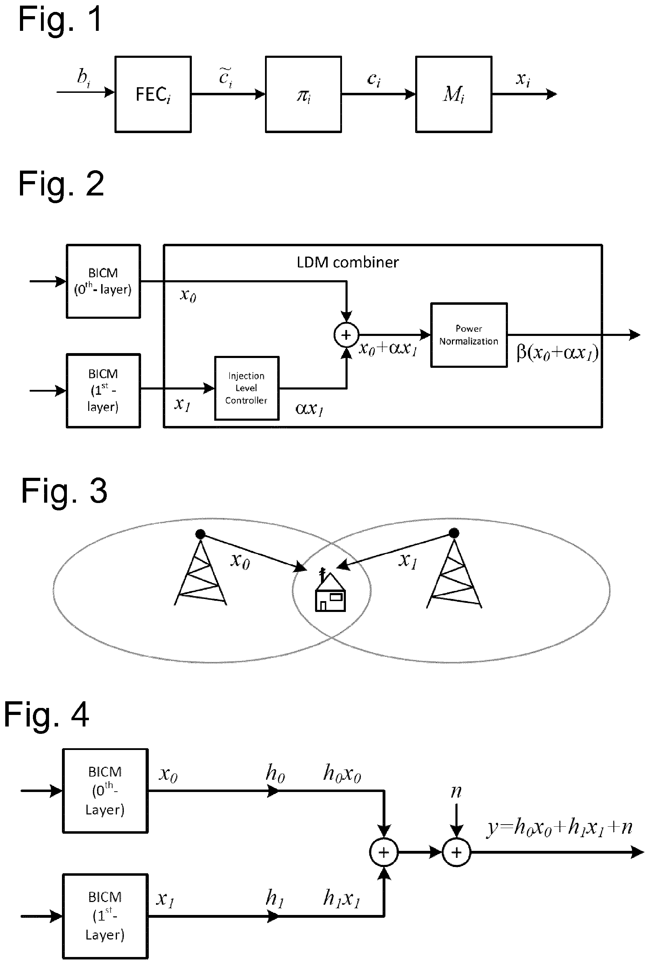

The general concept of superposition modulation builds on multiple BICM-encoded signals (BICM meaning Bit-Interleaved Coded Modulation) and their linear combination. In contrast to Space-Time-Block Codes, which aim at improving the reliability of transmission by introducing redundancy, the aim here is to increase transmission capacity. A basic BICM-block for the $i$-th layer is depicted in Figure 1. Information bits $b_i$ enter a forward error correction (FEC) encoder $FEC_i$, which adds redundancy to the information bits, yielding encoded bits $\tilde{c}_i$. Generally, any type of FEC code may be employed, such as a low-density parity check (LDPC) code. The encoded bits are entering the bit-interleaver $\pi_i$

yielding bit-interleaved codebits $c_i$, which are subsequently mapped to cells $x_i$ taken from an arbitrary alphabet $\mathcal{A}_i$, e.g. from a QAM-alphabet.

In practice, the concept of superposition modulation, i.e., the linear combination of multiple signals, can be realized in various forms depending on the position in the system where the superposition actually occurs. Roughly, these positions are located either at the transmitter or at the receiver.

In ATSC 3.0, the superposition occurs at the transmitter (cf. Figure 2). The scheme is called Layered-Division-Multiplexing (LDM) and consists of two layers. In the context of ATSC 3.0, the first layer is called Core layer, and the second layer is called Enhanced layer. The Core layer carries a low-rate service $x_0$ aimed at mobile reception, while the Enhanced layer carries a high-rate service $x_1$ aimed at stationary reception. To this end, the power of the Enhanced layer can be lowered by an injection level controller, which is provided with an injection level $0<\alpha\leq1$.

The corresponding receiver operation is understood such that a mobile receiver, which is interested in the Core layer only, also detects the Core layer only. A stationary receiver interested in the Enhanced layer is required to perform Successive Interference Cancellation, i.e., the Core layer is detected first. Assuming that the Core layer is detected successfully, it is then remodulated, and the remodulated cells are subtracted from the received cells in order to detect eventually the Lower layer.

Wideband-Transmission (WiB) is a next generation DTT system which utilizes a frequency reuse factor of 1 and thus explicitly allows transmitters to interfere. Additional aspects of WiB are the use of a very large bandwidth (possibly the whole remaining UHF-band currently used for traditional DTT amounting to roughly 220 MHz) and a highly robust transmission mode in order to cope with the interference and thus a starkly reduced transmission power compared to current transmission concepts.

Figure 3 illustrates the concept of WiB for two transmitters emitting signals $x_0$ and $x_1$ in the same frequency band. The ellipses represent the coverage area of the transmitters. The receiver in the mush area will observe the linear combination of both transmitted signals with weighting factors (channel coefficients) that reflect the propagation conditions.

As shown above, LDM and WiB are particular instances of Superposition Modulation (SM). While LDM explicitly adds transmit signals at the transmitter, WiB implicitly leads to the summation of transmitted signals at the receiver which is due to the usage of the same frequency band.

Thus, in principle, for the receiver front-end it is irrelevant in which way the superposition occurred. A system model applicable to both, LDM and WiB, is shown in Figure 4. The coefficients $h_o$ and $h_1$ can serve either as scaling factors or as channel coefficients. In the former case the system model represents LDM, in the latter case it represents WiB.

For completeness' sake, it is noted that in 3GPP, Multiuser Superposition Transmission (MUST) describes three additional variants of SM, called Cat-1, Cat-2, and Cat-3 (cf. 3GPP TR 36.859, "Study on Downlink Multiuser Superposition Transmission (MUST) for LTE (Release 13)"). Cat-1 and Cat-2 can be mapped to LDM, while Cat-3 cannot. Cat-3 uses a single mother constellation, and assigns different services to different bit-levels. It is thus similar to hierarchical modulation, and out of the scope of the present invention.

With regards to the system model shown in Figure 4, the received signal $y$ reads

$$y = h_0 x_0 + h_1 x_1 + n, \qquad (1)$$

with $h_o$ and $h_1$ denoting the scaling factors for LDM or channel coefficients for WiB and n denoting additive white Gaussian noise. The transmitted cells are chosen from a respective constellation alphabet, $x_0 \in \mathcal{A}_0$ and $x_1 \in \mathcal{A}_1$. The sizes of the alphabets are denoted by $S_0 = |\mathcal{A}_0|$ and $S_1 = |\mathcal{A}_1|$. A particular transmitted cell is picked from the corresponding alphabet by a function which maps bit labels to cells, e.g., $x_0 = \mathcal{M}_0(\boldsymbol{c}_0)$ for the upper layer. Here, the mapping function reads $\mathcal{M}_0(\cdot)$ and the bit label $\boldsymbol{c}_0 = (c_0(0), c_0(1), \ldots c_0(\log_2(S_0) - 1))$ with the individual codebits denoted as $c_0(i) \in \{0,1\}$. The same holds for the second layer, $x_1 = \mathcal{M}_1(\boldsymbol{c}_1)$. For demapping of the received signal, an inverse mapping function is helpful. To this end, $\mathcal{M}_{0,i}^{-1}(\cdot)$ is defined as the function which takes a cell from the alphabet $\mathcal{A}_0$ as its argument and returns the $i$-th bit $c_0(i)$, i.e., $c_0(i) = \mathcal{M}_{0,i}^{-1}(x_0)$. Similarly, for the second layer $c_1(i) = \mathcal{M}_{1,i}^{-1}(x_1)$ holds. Additionally, $\mathcal{A}_0^b(i)$ denotes the set of all cells from the alphabet $\mathcal{A}_0$ with bit $c_0(i) = b$.

The definition of an a posteriori channel L-value of the first layer reads

$$L_{ch,0}(i) = \log \frac{p(c_0(i) = 0|y)}{p(c_0(i) = 1|y)}.\qquad (2)$$

By applying the law of total probability, i.e., by suitably averaging over all cell combinations, this can be transformed into

$$L_{ch,0}(i) = \log \frac{\sum_{x_0 \in \mathcal{A}_0^0(i)} \sum_{x_1 \in \mathcal{A}_1} p(y|x_0, x_1) P(x_0) P(x_1)}{\sum_{x_0 \in \mathcal{A}_0^1(i)} \sum_{x_1 \in \mathcal{A}_1} p(y|x_0, x_1) P(x_0) P(x_1)}. \qquad (3)$$

Iterative demapping becomes feasible by substituting the a priori probabilities, $P(x_0)$ and $P(x_1)$, with extrinsic information obtained from FEC-decoding of the first and second layer. Exploiting additionally the fact that $\mathcal{M}_{0,i}^{-1}(x_0) = c_0(i)$ and assuming that the bit-interleaver $\pi_0$ breaks statistical dependencies, it is found that

$$P(x_0) = \prod_{m=0}^{\log_2(S_0)-1} P\left(\mathcal{M}_{0,m}^{-1}(x_0)\right). \qquad (4a)$$

It should be clear that on the first demapping pass, the a priori probabilities are unknown and thus they are assumed to be equally distributed with $P(x_0) = P(x_1) = 1/2$. Furthermore, from the definition of an L-Value, $L_a = \log P(b = 0)/P(b = 1)$, the connection of the extrinsic soft-information to the bits $b$ can be made, i.e., $P(b = 0) = 1/(1 + \exp(-L_a))$ and $P(b = 0) = \frac{\exp(-L_a)}{1+\exp(-L_a)}.$ The a priori information for the cell $x_0$ thus reads

$$P(x_0) = \prod_{m=0}^{\log_2(S_0)-1} \frac{e^{-c_0(m)\cdot L_{a,0}(m)}}{1 + e^{-L_{a,0}(m)}}. \qquad (4b)$$

Similarly, the a priori information for a cell $x_1$ of the second layer reads

$$P(x_1) = \prod_{n=0}^{\log_2(S_1)-1} \frac{e^{-c_1(n)\cdot L_{a,1}(n)}}{1 + e^{-L_{a,1}(n)}}. \qquad (4c)$$

With (4b) and (4c) inserted into (3), the a posteriori channel L-value for the first layer reads

$$L_{ch,0}(i) \qquad (5a)$$

$$= \log \frac{\sum_{x_0 \in \mathcal{A}_0^0(i)} \sum_{x_1 \in \mathcal{A}_1} p(y|x_0, x_1) e^{-\sum_{m=0}^{\log_2(S_0)-1} c_0(m)L_{a,0}(m) - \sum_{n=0}^{\log_2(S_1)-1} c_1(n)L_{a,1}(n)}}{\sum_{x_0 \in \mathcal{A}_0^1(i)} \sum_{x_1 \in \mathcal{A}_1} p(y|x_0, x_1) e^{-\sum_{m=0}^{\log_2(S_0)-1} c_0(m)L_{a,1}(m) - \sum_{n=0}^{\log_2(S_1)-1} c_1(n)L_{a,1}(n)}}.$$

And similarly, with (4b) and (4c) inserted into (3), the a posteriori channel L-value for the second layer reads

$$L_{ch,1}(i) \qquad (5b)$$

$$= \log \frac{\sum_{x_0 \in \mathcal{A}_0} \sum_{x_1 \in \mathcal{A}_1^0(i)} p(y|x_0, x_1) e^{-\sum_{m=0}^{\log_2(S_0)-1} c_0(m)L_{a,0}(m) - \sum_{n=0}^{\log_2(S_1)-1} c_1(n)L_{a,1}(n)}}{\sum_{x_0 \in \mathcal{A}_0} \sum_{x_1 \in \mathcal{A}_1^1(i)} p(y|x_0, x_1) e^{-\sum_{m=0}^{\log_2(S_0)-1} c_0(m)L_{a,0}(m) - \sum_{n=0}^{\log_2(S_1)-1} c_1(n)L_{a,1}(n)}}.$$

The conditional probability of the received cell $y$ is Gaussian with noise power $\sigma_n^2$ and reads

$$p(y|x_0, x_1) = \frac{1}{\pi \sigma_n^2} \exp\left(-\frac{1}{\sigma_n^2} |y - h_0 x_0 - h_1 x_1|^2\right) \qquad (5c)$$

Eq. (5a) and (5b) can be efficiently computed by repeatedly using the max-star operation, i.e., *max* *(*a, b*) = log($e^a$ + $e^b$) = max(*a, b*) + log (1 + $e^{-|a-b|}$). On close inspection, (5a) and (5b) exploit a priori information about the bits themselves, that is $L_{a,0}(m)$ and $L_{a,1}(m)$ for *m = i*. An elementary principle of any iterative detection scheme is the propagation of truly extrinsic information between component decoders to avoid feeding back statistically dependent information (cf. the article "The Turbo Principle: Tutorial Introduction and State of the Art" by J. Hagenauer, Proc. International Symposium on Turbo Codes and Related Topics, 1997). Hence, the a priori information needs to be subtracted from the demapping output, i.e., the a posteriori channel information, before passing it on to the next decoding stage.

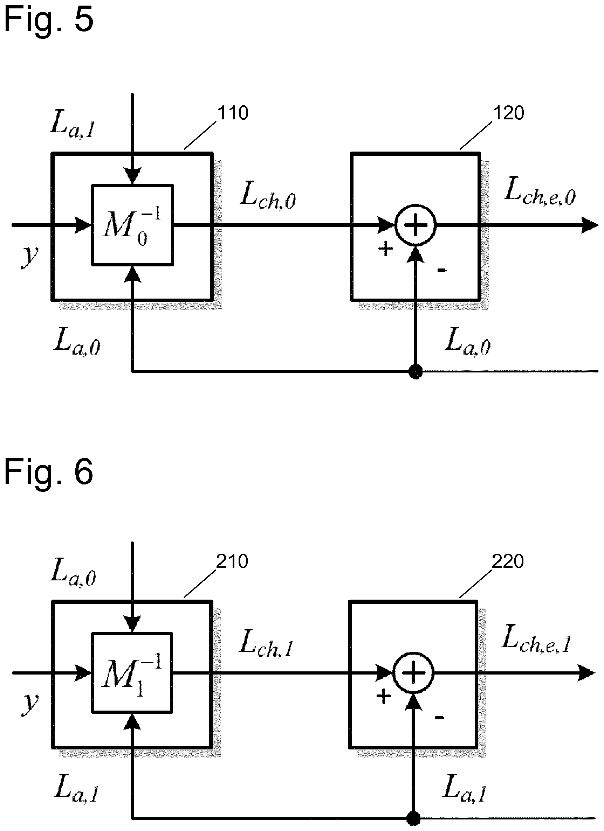

Figure 5 is a block diagram which illustrates the process for computing extrinsic channel information for the first layer. The demapper 110 accepts three input signals, one of which is the received signal, and two of which are the a priori information generated by the corresponding FEC-decoders, and computes $L_{ch,0}(i)$ for $0 \leq i < \log_2(S_0)$ according to Equation (5a). Subtractor 120 subtracts the a priori information $L_{a,0}$ from the demapping output.

Not shown in the Figures is the receiver which may comprises a conventional OFDM demodulator followed by a frequency deinterleaver and a time deinterleaver for receiving the compound signal. Both the OFDM demodulator and the frequency deinterleaver and the time deinterleaver are generally known in the art.

Figure 6 is a block diagram which illustrates the process for computing extrinsic channel information for the second layer. The demapper 210 accepts three input signals, one of which is the received signal, and two of which are the a priori information generated by the corresponding FEC-decoders, and computes $L_{ch,1}(i)$ for $0 \leq i < \log_2(S_1)$ according to Equation (5b). Subtractor 220 subtracts the a priori information $L_{a,1}$ from the demapping output.

The demapping operation performed by demappers 110 and 210 may be based also on channel state information, which may be determined beforehand, for instance, from pilot signals. Details on how channel state information is obtained and on how channel state information is employed for performing the demapping operation, however, are not relevant for the present invention.

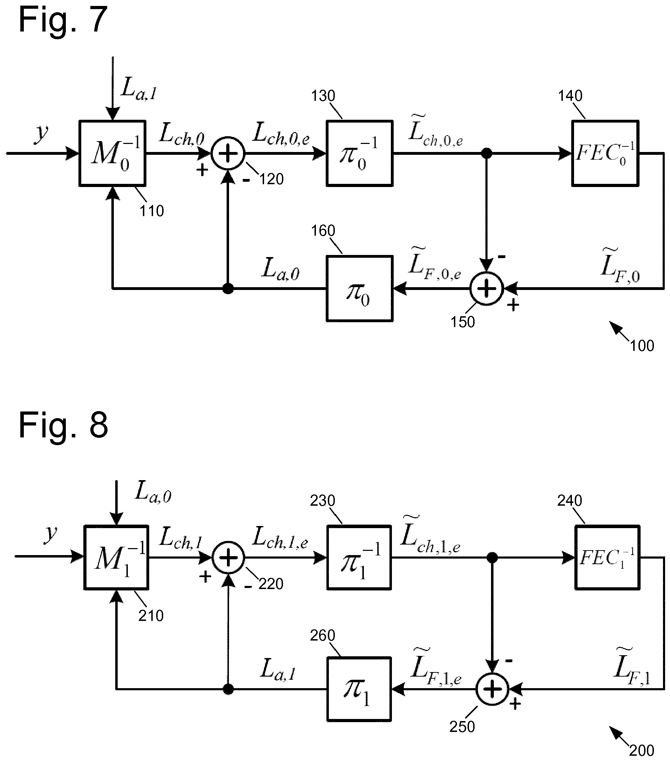

As an intermediate step onwards to a full iterative demapper, the FEC-decoding stages together with the appropriate bit deinterleavers and bit interleavers are added to the demappers of the first and second layer. Together they form the partial demodulators of the first and the second layer as shown in Figures 7 and 8, respectively.

As shown in Figure 7, the extrinsic channel L-values $L_{ch,0,e}$ are passed through the bit-deinterleaver 130, yielding deinterleaved soft-information $\tilde{L}_{ch,0,e}$ about the first layer's codebits, which are then passed to the FEC-decoder 140, which performs a version of belief-propagation decoding, e.g. the sum-product-algorithm (SPA) in case of LDPC FEC-coding. Belief-propagation decoding is generally known in the art and details of specific algorithms are not relevant for the present invention.

Belief-propagation decoding produces a posteriori FEC L-values $\tilde{L}_{F,0}$, based on which extrinsic FEC L-values $\tilde{L}_{F,0,e}$ are obtained by subtracting the extrinsic channel L-values $\tilde{L}_{ch,0,e}$ by means of subtractor 150. The result is then passed through the bit-interleaver 160 to serve as a priori information $L_{a,0}$ for the demapper 110 but also, crucially, for the demodulation of the second layer.

Based on the upper layer decoder and the lower layer decoder the partial iterative demodulator 200 of the second layer follows the same schema, which is shown in Figure 8. In order to avoid redundancy, a detailed explanation of the elements of Figure 8 is omitted.

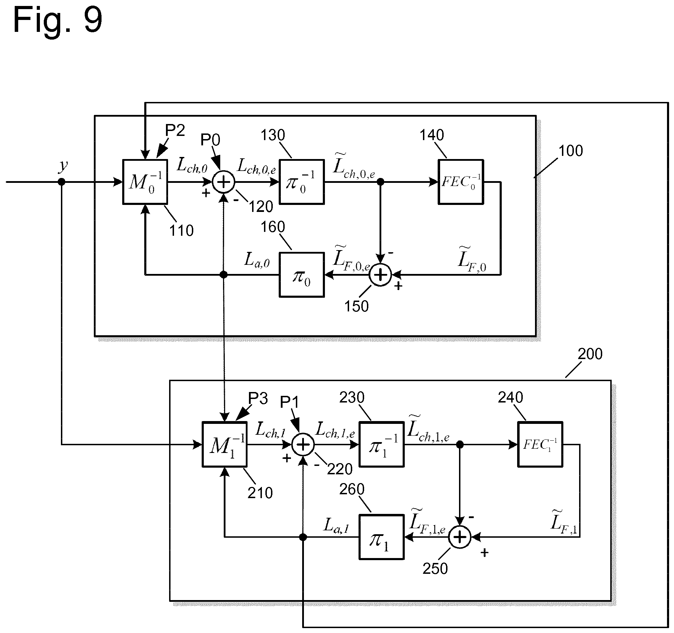

Figure 9 is a block diagram of a complete iterative demapper according to an embodiment of the present invention for demapping a superposition modulated signal y, which comprises a first layer and a second layer. A generalization to superposition modulated signals with more than two layers is straightforward.

The block diagram of Figure 9 is a combination of the partial iterative demodulators of the first and the second layer shown in Figures 7 and 8, respectively, wherein like elements are denoted by like reference numerals. A repetition of the detailed explanation of these elements is omitted.

Arrows in Figure 9 indicate the flow of information during operation. A corresponding method for iteratively demapping the input signal is summarized in the following listing:

　0) Parameter settings

　　a. Choose a maximum number of outer iterations $i_{max} \geq 0$. (This is the number of iterations between second and first layer demodulator.)

　　b. Choose a maximum number of inner iterations $i_{max,FEC0} \geq 0$ and $i_{max,FEC1} \geq 0$. (This is the maximum number of FEC-decoder iterations employed in $FEC_0^{-1}$ and $FEC_1^{-1}$. )

c. Set outer iteration counter i to zero.

d. Initialize the a priori information by setting $L_{a,0}$ and $L_{a,1}$ to zero.

1) Demodulate the first layer

a. Demap the first layer according to Eq. (5a). This yields the a posteriori channel L-value of the first layer, $L_{ch,0}$.

b. Compute the extrinsic information for the upper layer, $L_{ch,0,e} = L_{ch,0} - L_{a,0}$.

c. Perform the bit-deinterleaving of $L_{ch,0,e}$, yielding $\tilde{L}_{ch,0,e}$,

d. Perform FEC-decoding of $\tilde{L}_{ch,0,e}$, yielding $\tilde{L}_{F,0}$

e. Compute the extrinsic FEC information $\tilde{L}_{F,0,e} = \tilde{L}_{F,0} - \tilde{L}_{ch,0,e}$.

f. Perform the bit-deinterleaving of $\tilde{L}_{F,0,e}$, yielding $L_{a,0}$.

2) Demodulate the second layer

a. Demap the second layer according to Eq. (5b). This yields $L_{ch,1}$.

b. Compute the extrinsic information for the lower layer, $L_{ch,1,e} = L_{ch,1} - L_{a,1}$.

c. Perform the bit-deinterleaving of $L_{ch,1,e}$, yielding $\tilde{L}_{ch,1,e}$

d. Perform FEC-decoding of $\tilde{L}_{ch,1,e}$, yielding $\tilde{L}_{F,1}$

e. Compute the extrinsic FEC information $\tilde{L}_{F,1,e} = \tilde{L}_{F,1} - \tilde{L}_{ch,1,e}$.

f. Perform the bit-deinterleaving of $\tilde{L}_{F,1,e}$, yielding $L_{a,1}$.

3) Check if an outer code (can be BCH or CRC) of the desired layer confirms that there are no errors. If so, terminate the demodulation. Otherwise go to the next step 4.

4) Increase $i$ by 1. If $i \leq i_{max}$, go to step 1. If $i > i_{max}$, terminate the demodulation.

The general concept of iterative decoding is known since the first days of turbo coding as invented by Berrou et al. In the configuration of the Figure 9, however, it should be appreciated that to generate extrinsic information from the demapper output only one of the a priori L-values is being subtracted, i.e., $L_{a,0}$ from $L_{ch,0}$ (rather than $L_{a,1}$) and $L_{a,1}$ from $L_{ch,1}$ (rather than $L_{a,o}$). For clarity, these positions are marked by P0 and P1 in Figure 9. At first glance, this approach constitutes a deviation from the principle to pass on only extrinsic information as set forth in the above cited article by J. Hagenauer. By careful inspection of the positions, marked by P2 and P3, one can observe that $L_{a,1}$ fed into $\mathcal{M}_0^{-1}$ is implicitly subtracted from the demapper output $L_{ch,1}$ at position P1, and $L_{a,0}$ fed into $\mathcal{M}_1^{-1}$ is implicitly subtracted from the demapper ouput $L_{ch,0}$ at P0. Feeding back statistically dependent information is thus avoided.

Hard decision SIC as described in the article by S. I. Park et al., is the standard approach for detecting SM-based transmission schemes like LDM and WiB. But Hard decision implies information loss. FEC-decoders naturally provide soft information and reliability information at their output, that is, the magnitude of the L-values of FEC-decoded codebits hint at their reliability. The iterative demapper shown in Figure 9 makes use of this soft-information by exchanging extrinsic soft-information between partial demodulators.

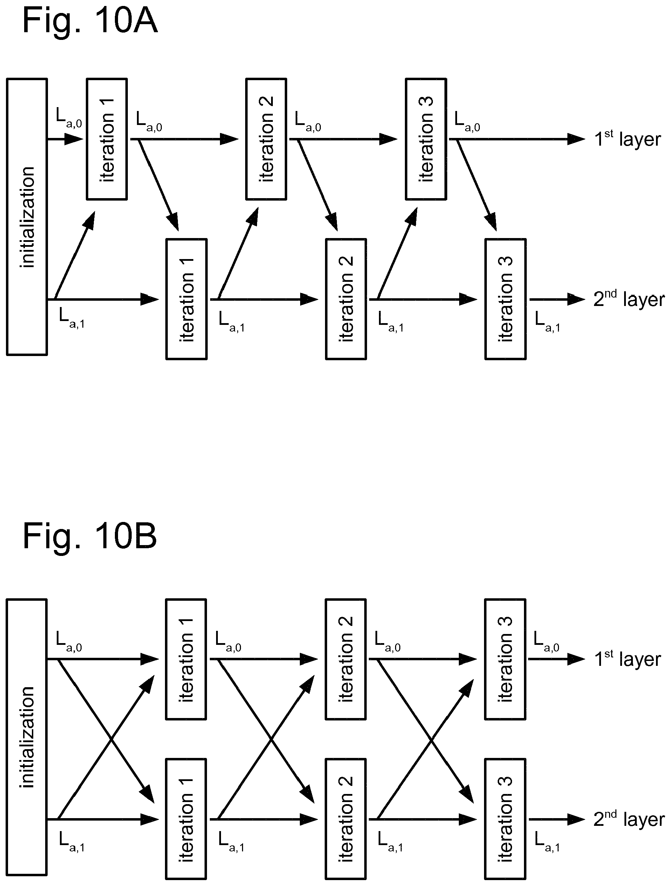

Although it is suggested by the above listing that demodulation steps for the first layer and the second layer are performed sequentially, both steps may also be performed in parallel. Both options may have specific advantages in terms of hardware requirements and efficiency. However, the difference in these two options is not so much related to implementation details but on how information, in particular updated values of the a priori information, are exchanged between processing of the first layer and the second layer. This difference is illustrated in Figs. 10A and 10B, which show the flow of information for sequential and parallel processing, respectively.

In a situation where demodulation steps for the first layer and the second layer are performed sequentially, the first iteration of demodulating the first layer is based on the initialization values for the a priori information, i.e., on $L_{a,0}$ = $L_{a,1}$ = 0. The first iteration of demodulating the second layer, however, is already based on the new a prior value $L_{a,0}$ computed by the demodulation step for the first layer. Therefore, sequential operation may be beneficial in a situation where signal strength of the first layer is dominating over the second layer, as it may be the case in LDM.

On the other hand, when demodulation steps for the first layer and the second layer are performed in parallel, the first iteration for the first layer and the first iteration of the second layer are both based on the initialization values for the a priori information, i.e., on $L_{a,0}$ = $L_{a,1}$ = 0. Subsequent iterations for both layers are then based on results of the immediately preceding steps. Hence, parallel operation treats both layers equal and may be beneficial in a situation where both signal strengths are on a par, as it might be the case in WiB.

Summarizing, the present invention provides a method and apparatus for demapping superposition modulated signals with improved efficiency. This is achieved by providing a separate iterative demapper for each layer of a superposition modulated signal, and to configure each demapper to exchange soft-information with the other demappers such that each layer is demapped on the basis of soft-information relating to all layers. In this manner, no hard decisions on the FEC decoder output have to be taken and no information is lost.

**Claims**

1. A method for iteratively demapping a received signal ($y$), said received signal comprising a superposition of at least a first BICM-encoded signal ($x_0$) and a second BICM-encoded signal ($x_1$), said method comprising the steps of:

   initializing a priori L-values ($L_{a,0}$) for the first signal ($x_0$) and a priori L-values ($L_{a,1}$) for the second signal;
   computing, from the received signal ($y$), a posteriori L-values ($L_{h,0}$) for the first signal ($x_0$);
   updating a priori L-values ($L_{a,0}$) for the first signal on the basis of the computed a posteriori L-values ($L_{ch,0}$) for the first signal ($x_0$);
   iterating, for the first signal ($x_0$), the steps of computing the a posteriori L-values ($L_{ch,0}$) and updating the a priori L-values ($L_{a,0}$);
   computing, from the received signal ($y$), a posteriori L-values ($L_{ch,1}$) for the second signal ($x_1$);
   updating a priori L-values ($L_{a,1}$) for the second signal ($x_1$) on the basis of the computed a posteriori L-values ($L_{ch,1}$) for the second signal ($x_1$);
   iterating, for the second signal ($x_1$), the steps of computing the a posteriori L-values ($L_{ch,1}$) and updating the a priori L-values ($L_{a,1}$);

   **characterized in that**
   the a posteriori L-values ($L_{h,0}$) for the first signal ($x_0$) are computed on the basis of the a priori L-values ($L_{a,0}$) for the first signal ($x_0$) and the a priori L-values ($L_{a,1}$) for the second signal ($x_1$); and
   the a posteriori L-values ($L_{ch,1}$) for the second signal ($x_1$) are computed on the basis of the a priori L-values ($L_{a,0}$) for the first signal ($x_0$) and the a priori L-values ($L_{a,1}$) for the second signal ($x_1$).

2. The method of claim 1, wherein the a posteriori L-values ($L_{ch,0}$) for the first signal ($x_0$) and the a posteriori L-values ($L_{ch,1}$) for the second signal ($x_1$) are computed according to

$$L_{ch,0}(i) = \log \frac{\sum_{x_0 \in \mathcal{A}_0^0(i)} \sum_{x_1 \in \mathcal{A}_1} p(y|x_0,x_1) e^{-\sum_{m=0}^{\log_2(S_0)-1} c_0(m)L_{a,0}(m) - \sum_{n=0}^{\log_2(S_1)-1} c_1(n)L_{a,1}(n)}}{\sum_{x_0 \in \mathcal{A}_0^1(i)} \sum_{x_1 \in \mathcal{A}_1} p(y|x_0,x_1) e^{-\sum_{m=0}^{\log_2(S_0)-1} c_0(m)L_{a,1}(m) - \sum_{n=0}^{\log_2(S_1)-1} c_1(n)L_{a,1}(n)}}$$

and

$$L_{ch,1}(i) = \log \frac{\sum_{x_0 \in \mathcal{A}_0} \sum_{x_1 \in \mathcal{A}_1^0(i)} p(y|x_0, x_1) e^{-\sum_{m=0}^{\log_2(S_0)-1} c_0(m) L_{a,0}(m) - \sum_{n=0}^{\log_2(S_1)-1} c_1(n) L_{a,1}(n)}}{\sum_{x_0 \in \mathcal{A}_0} \sum_{x_1 \in \mathcal{A}_1^1(i)} p(y|x_0, x_1) e^{-\sum_{m=0}^{\log_2(S_0)-1} c_0(m) L_{a,0}(m) - \sum_{n=0}^{\log_2(S_1)-1} c_1(n) L_{a,1}(n)}},$$

wherein $y$ is the received signal, $\mathcal{A}_0$ and $\mathcal{A}_1$ denote the constellation alphabet for the first and the second signal, respectively, $S_0 = |\mathcal{A}_0|$ and $S_1 = |\mathcal{A}_1|$ denote the size of the respective constellation alphabet, $c_k(i) \in \{0,1\}$ is the value of the $i$-th bit mapped to cell $x_k \in \mathcal{A}_k$, and $\mathcal{A}_k^b(i)$ denotes the set of all cells from the alphabet $\mathcal{A}_k$ with bit $c_k(i) = b$, and $p(y|x_0,x_1)$ is the conditional probability of receiving $y$ given $x_0$ and $x_1$.

3. The method of claim 1 or 2, further comprising the steps of
computing extrinsic L-values ($L_{ch,0,e}$) for the first signal ($x_0$) by subtracting the a priori L-values ($L_{a,0}$) for the first signal ($x_0$) from the a posteriori L-values ($L_{ch,0}$) for the first signal ($x_0$), wherein the a priori L-values ($L_{a,0}$) for the first signal ($x_0$) are updated on the basis of the extrinsic L-values ($L_{ch,0,e}$) for the first signal ($x_0$); and
computing extrinsic L-values ($L_{ch,1,e}$) for the second signal ($x_1$) by subtracting the a priori L-values ($L_{a,1}$) for the second signal ($x_1$) from the a posteriori L-values ($L_{ch,1}$) for the second signal ($x_1$), wherein the a priori L-values ($L_{a,1}$) for the second signal ($x_1$) are updated on the basis of the extrinsic L-values ($L_{ch,1,e}$) for the second signal ($x_1$).

4. The method of claim 3, wherein updating the a priori L-value ($L_{a,0}$, $L_{a,1}$) for at least one of the first and the second signal ($x_0$, $x_1$) comprises:

   deinterleaving the extrinsic L-values ($L_{ch,0,e}$, $L_{ch,1,e}$) for the at least one signal ($x_0$, $x_1$);
   performing FEC decoding on the deinterleaved extrinsic L-values for the at least one signal ($x_0$, $x_1$);
   subtracting the deinterleaved extrinsic L-values for the at least one signal ($x_0$, $x_1$) from the result of the FEC decoding process; and
   interleaving a result of the subtraction.

5. The method of any of claims 1 to 4, wherein the iterating steps are performed such that a first iteration for computing the a posteriori L-values ($L_{ch,0}$) for the first signal ($x_0$) is based on the initialized a priori L-values ($L_{a,0}$, $L_{a,1}$) for the first and the second signal ($x_0$, $x_1$) and that a first iteration for computing the a posteriori L-values ($L_{ch,1}$) for the second signal ($x_1$) is based on the updated a priori L-values ($L_{a,0}$) for the first signal and on the initialized a priori L-values ($L_{a,1}$) for the second signal ($x_1$).

6. The method of any of claims 1 to 4, wherein the iterating steps are performed such that both a first iteration for computing the a posteriori L-values ($L_{ch,0}$) for the first signal ($x_0$) and a first iteration for computing the a posteriori L-values ($L_{ch,1}$) for the second signal ($x_1$) are based on the initialized a priori L-values ($L_{a,0}$, $L_{a,1}$) for the first and the second signal ($x_0$, $x_1$).

7. The method of any of claims 1 to 6, wherein the received signal ($y$) is a layered-division multiplexing signal with the first signal ($x_0$) representing a first layer and the second signal ($x_1$) representing a second layer.

8. The method of any of claims 1 to 6, wherein the first signal ($x_0$) is a first wideband transmission signal transmitted by a first transmitter and the second signal ($x_1$) is a second wideband transmission signal transmitted by a second transmitter in the same frequency band as the first wideband transmission signal.

9. An apparatus for iteratively demapping a received signal ($y$), said received signal comprising a superposition of at least a first BICM-encoded signal ($x_0$) and a second BICM-encoded signal ($x_1$), said apparatus comprising:

   a first demapper for demapping the first signal from the received signal by iteratively computing a posteriori L-values ($L_{ch,0}$) of the first signal and updating a priori L-values ($L_{a,0}$) of the first signal on the basis of the computed a posteriori L-values ($L_{ch,0}$) of the first signal; and
   a second demapper for demapping the second signal from the received signal by iteratively computing a posteriori L-values ($L_{ch,1}$) of the second signal and updating a priori L-values ($L_{a,1}$) of the second signal on the basis of the computed a posteriori L-values ($L_{ch,1}$) of the second signal,

**characterized in that**

the first demapper is configured for computing the a posteriori L-values ($L_{h,0}$) of the first signal on the basis of the a priori L-values ($L_{a,0}$) of the first signal and the a priori L-values ($L_{a,1}$) of the second signal; and

the second demapper is configured for computing the a posteriori L-values ($L_{ch,1}$) of the second signal on the basis of the a priori L-values ($L_{a,0}$) of the first signal and the a priori L-values ($L_{a,1}$) of the second signal.

# Fig. 1

# Fig. 2

# Fig. 3

# Fig. 4

## Fig. 5

## Fig. 6

## Fig. 7

## Fig. 8

# Fig. 9

# Fig. 10A

# Fig. 10B

Europäisches
Patentamt

European
Patent Office

Office européen
des brevets

# EUROPEAN SEARCH REPORT

**Application Number**

EP 16 20 3534

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/022088 A1 (HATEFI ATOOSA [FR] ET AL) 24 January 2013 (2013-01-24) | 1-4,8,9 | INV.<br>H04L1/00 |
| A | * figures 10-12 *<br>* paragraph [0138] *<br>* paragraph [0144] - paragraph [0153] * | 5-7 | H04L25/03<br>H03M13/37<br>H03M13/45 |
| X | EP 2 255 473 A1 (NTT DOCOMO INC [JP]) 1 December 2010 (2010-12-01) | 1,5-7,9 | ADD.<br>H04L27/34 |
| A | * figure 3 *<br>* paragraph [0046] *<br>* paragraph [0055] - paragraph [0067] *<br>* claims 1-25 * | 2-4,8 | |
| X | US 2013/034044 A1 (HATEFI ATOOSA [FR] ET AL) 7 February 2013 (2013-02-07) | 1-4,8,9 | |
| A | * paragraph [0148] - paragraph [0154] *<br>* figures 10-12 * | 5-7 | |
| A | XIAODONG WANG ET AL: "Iterative (Turbo) Soft Interference Cancellation and Decoding for Coded CDMA",<br>IEEE TRANSACTIONS ON COMMUNICATIONS, IEEE SERVICE CENTER, PISCATAWAY, NJ. USA,<br>vol. 47, no. 7, 1 July 1999 (1999-07-01), XP011009462,<br>ISSN: 0090-6778<br>* figure 1 *<br>* Section II.B * | 1-9 | TECHNICAL FIELDS SEARCHED (IPC)<br><br>H04L<br>H03M |

The present search report has been drawn up for all claims

| Place of search | Date of completion of the search | Examiner |
|---|---|---|
| Munich | 19 May 2017 | Gabry, Frederic |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 20 3534

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2017

| Patent document cited in search report | | | Publication date | Patent family member(s) | | | | Publication date |
|---|---|---|---|---|---|---|---|---|
| US 2013022088 | A1 | | 24-01-2013 | BR | 112012013266 | A2 | | 01-03-2016 |
| | | | | CN | 102742201 | A | | 17-10-2012 |
| | | | | EP | 2507930 | A1 | | 10-10-2012 |
| | | | | US | 2013022088 | A1 | | 24-01-2013 |
| | | | | WO | 2011067534 | A1 | | 09-06-2011 |
| EP 2255473 | A1 | | 01-12-2010 | EP | 2255473 | A1 | | 01-12-2010 |
| | | | | JP | 2011515917 | A | | 19-05-2011 |
| | | | | US | 2009220034 | A1 | | 03-09-2009 |
| | | | | WO | 2009111402 | A1 | | 11-09-2009 |
| US 2013034044 | A1 | | 07-02-2013 | CN | 102630374 | A | | 08-08-2012 |
| | | | | EP | 2478680 | A1 | | 25-07-2012 |
| | | | | US | 2013034044 | A1 | | 07-02-2013 |
| | | | | WO | 2011033237 | A1 | | 24-03-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. I. PARK.** Low Complexity Layered Division for AT-SC 3.0. *IEEE Transactions on Broadcasting,* March 2016, vol. 62 (1), 233-243
- **E. STARE ; J. J. GIMÉNEZ ; P. KLENNER.** WiB: a new system concept for digital terrestrial television (DTT). *IBC Conference,* 2016
- **P. P. BERGMANS ; T. M. COVER.** Cooperative broadcasting. *IEEE Trans. Inf. Theory,* May 1974, vol. 20 (3), 317-324
- Study on Downlink Multiuser Superposition Transmission (MUST) for LTE (Release 13). *3GPP TR 36.859*
- The Turbo Principle: Tutorial Introduction and State of the Art. **J. HAGENAUER.** Proc. International Symposium on Turbo Codes and Related Topics. 1997